# EUROPEAN PATENT APPLICATION

(11) **EP 3 035 782 A1**
(43) Date of publication of application: **22.06.2016**
(21) Application number: 14425155.0
(22) Date of filing: 19.12.2014
(51) Int. Cl.: H05K 7/14

(54) **Compact power electronic system**

(71) Applicant: Tecnologie Future S.r.l., 02100 Rieti (RI) (IT)
(72) Inventor: Pace, Giovanni, 02100 Rieti RI (IT)
(74) Representative: Romano, Giuseppe

(57) **Abstract**

The present invention relates to a compact Power Electronic System with high grade of mechanical and chemical protection, intended for operation in multiple applications, comprising variable frequency inverter, power supplies and solar converters. Mentioned invention can also be suitable for outdoor applications and can also be either fixed on board of a motor or directly to the chassis of cabinets or power units. Preferred, but not exclusive application of the above mentioned invention, are Variable Frequency Drives or Inverters for Motor Drives.

## Description

The present invention relates to a Compact Power Electronic System with high grade of mechanical and chemical protection, intended for operation in multiple applications, comprising variable frequency inverter, power supplies and solar converters.

The mentioned invention is especially suitable in outdoor or "on field" applications and can be either fixed on board of a motor or directly on the chassis of cabinets, racks or power units.

Preferred, although not exclusive, application for the above mentioned invention, are Variable Frequency Drives or Inverters for Motor Drives.

Inverter for Motor Drive is a well-established technology since the 70s. They provide controlled frequency, torque and speed of electric motors.

Different solutions are already available on the market, which provide few of the mentioned features. Most of the solutions use off-the-shelf electronics, like: power modules, standard Surface mounting devices (SMD) and Pins through Holes devices (PTH) for the driver stage and controller stage. Therefore, a system made of such a different pre-assembled structures are extremely space consuming and in general relatively expensive.

Inverter for motor drives systems, nowadays, are mainly focusing on the control algorithms or on the architectures and topologies, like for example patent WO2013JP84805 or also patent KR20130026542, whilst only few patents, like the CN2011865400 refers to the mechanical structure, especially the once in the field of Industrial Drives.

The present invention seeks to provide a complete integrated power electronic system in an extremely compact form with an embedded thermal management system which can be used in outdoor applications.

One of the most promising application of the mentioned invention is the Variable Frequency Inverter for motor drive.

According to the present invention, there is provided a Compact Power Electronic Converter where the power electronics is embedded into a specific thermal management structure which is part of the mentioned inverter. The entire system is therefore made of a control stage, a driver stage, power supplies, auxiliaries and it is stacked in a compact structure.

The control and driver elements are accommodated in one, or maybe more than one, Printed Circuit Board(s), whilst the power electronics which may include the packaged power devices, but may also include the DC-Link capacitors, current sensing, temperature sensing, etc. are accommodated into a specific substrate directly connected via external terminals to the driver circuitry. Said substrate is intimately bonded to the chassis which may also provide adequate power dissipation at the same time.

According to the present invention, there is provided an Electronic system for operation in multiple applications, comprising a power substrate, which is intimately bonded into a metal enclosure which provide external protection and eventually power dissipation capability. Said power substrate can be populated with power semiconductors, current sensors, capacitors, resistors and other passive components used to run said system. Said power substrate is provided with terminals which are connected to one or more than one external printed circuit board populated with electronics devices used for driving and control of the said power substrate.

The metal enclosure may be provided with an external cover which further provide mechanical and chemical isolation. Said cover may be provided on top with control elements, such as knobs, levers, I/O ports, signal lights, displays and whatever necessary for the device control.

Embodiments of the present invention with now be described, by way of example, with reference to the accompanying drawings, in a preferable Motor Drive application in which:
Figure 1 is a top view of the entire system seen from the external enclosure;
Figure 2 is a top view of the power substrate;
Figure 3 is a closed up view of the power substrate;
Figure 4 and Figure 5 are exploded views of the entire embodiment of the system;
Figure 6 is a block diagram of the Electric System related to the mentioned embodiment of the present invention;

A complete integrated variable frequency inverter for motor drive in a compact form with an embedded thermal management system Electric Vehicle is provided as example of possible embodiment of the present invention.

For the purpose of illustration, this invention will be described with reference to a specific Variable frequency Drive, but it is also applicable to any kind of Power electronic Converter solution.

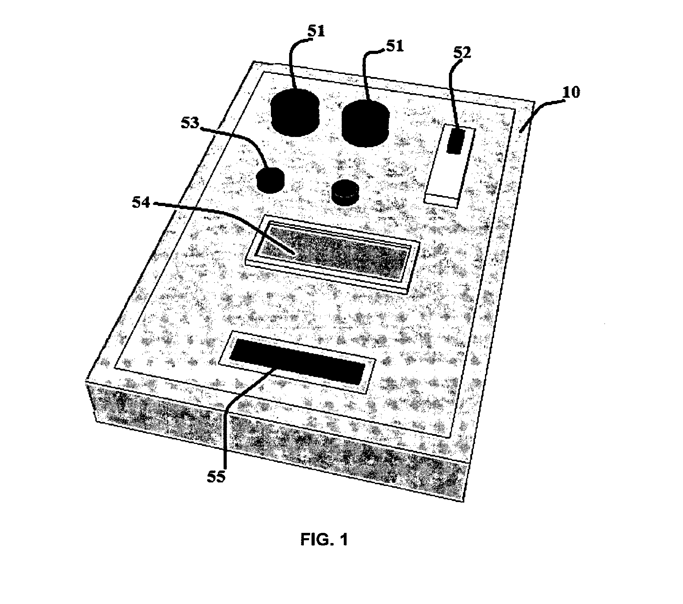

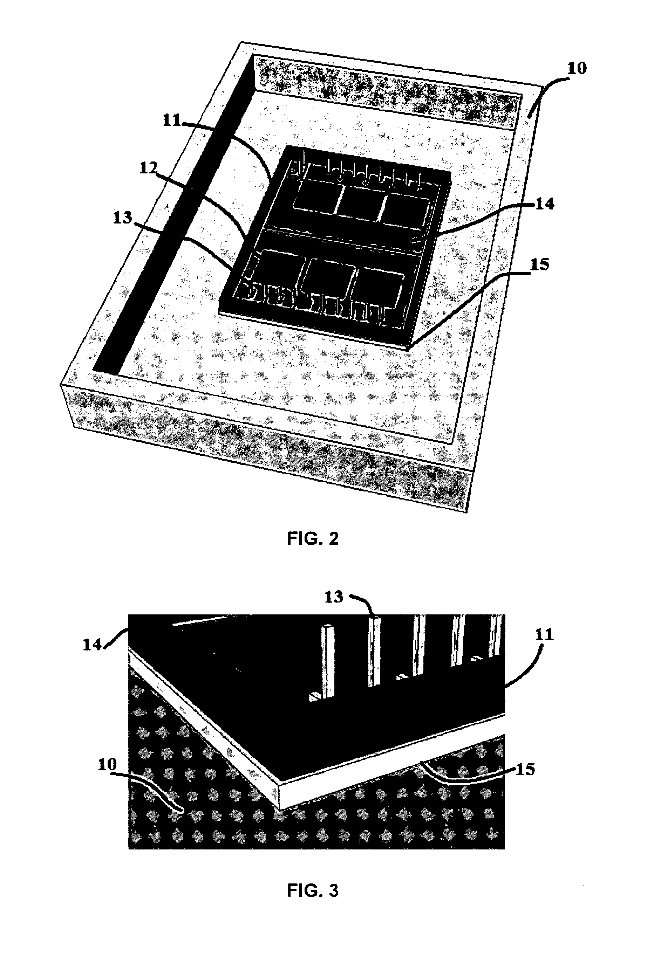

While figure 1 is a top view of the entire system seen from the external enclosure, figure 2 is a top view of the power substrate (14) where are shown the power semiconductors (12) and the substrate glued (15), in this case, on top of a metal enclosure (10); A plastic frame (11) defines the borders and provide a correct height to anchor the printed circuit board(s) (20, 30) on top.

Figure 3 is a closed up view of the power substrate (14) which is bonded (in this case glued, (15)) on top of the metal enclosure (10) which serves also as power dissipating element.

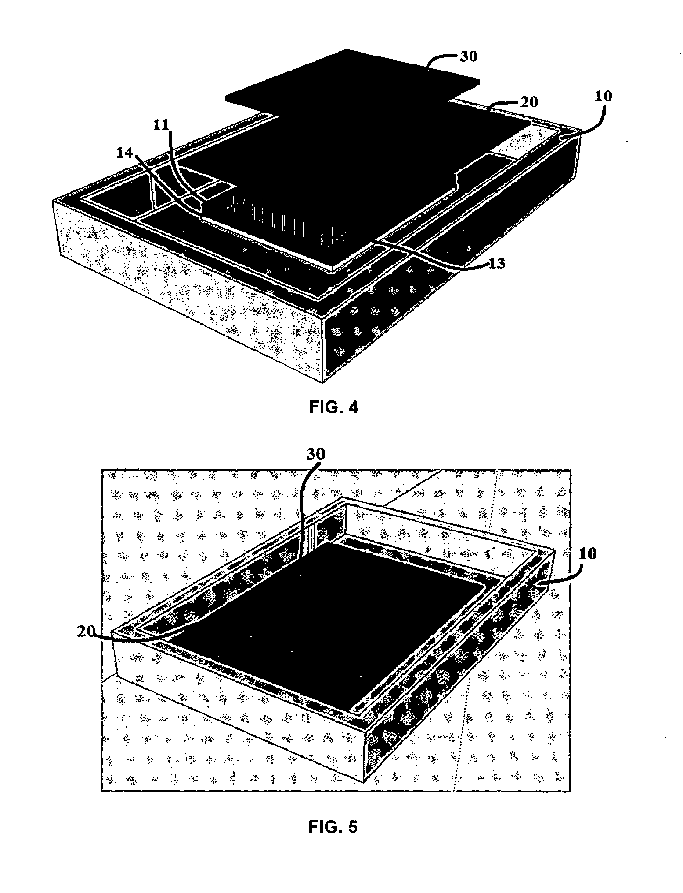

Figure 4 and Figure 5 are exploded views of the entire embodiment of the system, in which the control printed circuit board (30) and the driver printed circuit board (20) are displayed in transparency to show the power substrate (14) which is bonded on top of a metal enclosure (10) which work itself as enclosure and as power dissipating element at the same time.

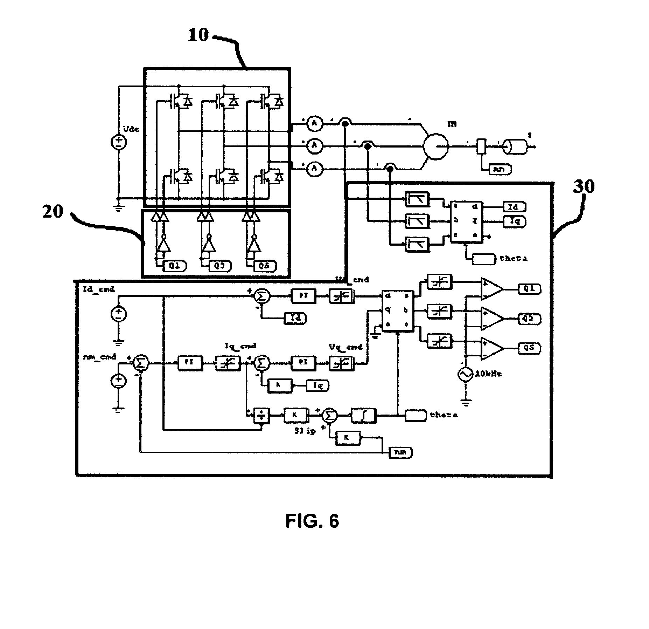

Figure 6 is a block diagram of the Electric System related to the mentioned embodiment of the present invention, where are shown the stages forming the system. I.e. power stage (10) which include the power devices and semiconductors, gate drivers included in the driver printed circuit board (20), and the control circuitry included in the control printed circuit board (30).

Figure 6 shows the complete diagram of said Variable Frequency Drive inverter for induction motors.

Power stage (10) is made of 6 IGBTs (12) attached on top of a substrate (14) provided with terminals (13). As shown in Figure 1 this embodiment is glued (15) on top of an aluminum enclosure (10) which provide mechanical and chemical protection and thermal heat sinking at the same time. The complete embodiment is described in Figure 6 (10). Furthermore, on top of the said structure a driver printed circuit board (20) and eventually a control circuit board (30) can be present. Externally, as shown in Figure 1, knobs (51), lever (52) and other control devices might be present (52, 53). According to an embodiment of the present invention, an electronic system for operation in multiple applications, comprises:
- a metal chassis (10) which may act as device enclosure and power dissipating unit at the same time;
- a power substrate (14) which is bonded (15) on top of one of the internal faces of the metal chassis (10), wherein said power substrate (14) may have one, or more than one power semiconductors (12), passive elements, sensor elements attached on its top surface, wherein said power substrate (14) may have one, or more than one, terminals (13) to interconnect the power substrate unit (14) to external circuitry (20, 30), characterized in that said power substrate provide thermal conductivity and galvanic isolation at the same time;
- an external circuitry (20, 30) which is made of one, or more than one, printed circuit board(s) or substrate(s) or laminate(s), said external circuitry being populated with all signals, controls and driving circuits and wherein said external circuitry may also include filters and auxiliary power supplies; and.
- one, or more than one, display(s) (54), knob(s) (51), lever(s) (52) and other control and user interface(s) (55) to provide a physical device interface and information to the user, said elements being built on top of the upper face of the metal chassis (10).

According to an embodiment, said substrate is made of any kind of ceramic sintered material, or any kind of Inter-metal Substrate or any kind of laminate, or any kind of Active Metal Brazing or any kind of glass fibers or any kind of Thin/Thick films.

According to an embodiment, said substrate including eventually power semiconductors (12), passive elements, sensor elements attached on its top surface will be fully covered by any kind of encapsulant, comprising: polyurethanes, Silicones, Epoxies, and any other organic or inorganic insulating materials intended to be used as chemical and mechanical protection.

According to an embodiment, said chassis (10) can be made of plastic, polymers, matrix composite materials, sintered materials or any kind of thermally conductive material.

According to an embodiment, the mentioned driving (20) and control (30) circuitries, including power supplies or auxiliaries, are not directly connected to the power substrate (14), but might use a different interconnect method, such as external wiring connection or other mechanical connectors, including press-fit, snap-on or fast-on connectors.

According to an embodiment, the mentioned power substrate (14) might be bonded or either soldered, or either glued, or either brazed, or either sintered on top of one of the internal surfaces of the said chassis (10).

According to an embodiment, the driving and control circuitry, including power supplies, auxiliaries and filters may lay on the same printed circuit board.

According to an embodiment, the chassis (10) might be attached, such as glued, bonded, connected or screwed on top of an external heat sink to provide an extension of the power dissipation capability of the said electronic system.

According to an embodiment, the chassis (10) might be attached, such as glued, bonded, connected or screwed on top of an external chassis, such as motor chassis or UPS cabinets or solar converter chassis and to be used on outdoor.

The present invention has been hereto described with reference to preferred embodiments thereof. It is understood that other embodiments might exist, all falling within the concept of the same invention, as defined by the protective scope of the claims hereinafter.

## Claims

1. An electronic system for operation in multiple applications, comprising:
- a metal chassis (10) which may act as device enclosure and power dissipating unit at the same time;
- a power substrate (14) which is bonded (15) on top of one of the internal faces of the metal chassis (10), wherein said power substrate (14) may have one, or more than one power semiconductors (12), passive elements, sensor elements attached on its top surface, wherein said power substrate (14) may have one, or more than one, terminals (13) to interconnect the power substrate unit (14) to external circuitry (20, 30), **characterized in that** said power substrate provide thermal conductivity and galvanic isolation at the same time;
- an external circuitry (20, 30) which is made of one, or more than one, printed circuit board or substrate or laminate, said external circuitry being populated with all signals, controls and driving circuits and wherein said external circuitry may also include filters and auxiliary power supplies; and.
- one, or more than one, display (54), knob (51), lever (52) and other control and user interface (55) to provide a physical device interface and information to the user, said elements being built on top of the upper face of the metal chassis (10).

2. The electronic system according to claim 1, wherein said substrate is made of any kind of ceramic sintered material, or any kind of Inter-metal Substrate or any kind of laminate, or any kind of Active Metal Brazing or any kind of glass fibres or any kind of Thin/Thick films.

3. The electronic system according to claim 1 and 2, wherein said substrate including eventually power semiconductors (12), passive elements, sensor elements attached on its top surface will be fully covered by any kind of encapsulant, comprising:
polyurethanes, Silicones, Epoxies, and any other organic or inorganic insulating materials intended to be used as chemical and mechanical protection.

4. The electronic system according to anyone of the preceding claims, wherein said chassis (10) can be made of plastic, polymers, matrix composite materials, sintered materials or any kind of thermally conductive material.

5. The electronic system according to anyone of the preceding claims, wherein the mentioned driving (20) and control (30) circuitries, including power supplies or auxiliaries, are not directly connected to the power substrate (14), but might use a different interconnect method, such as external wiring connection or other mechanical connectors, including press-fit, snap-on or fast-on connectors.

6. The electronic system according to anyone of the preceding claim, wherein the mentioned power substrate (14) might be bonded or either soldered, or either glued, or either brazed, or either sintered on top of one of the internal surfaces of the said chassis (10).

7. The electronic system according to anyone of the preceding claim, wherein the driving and control circuitry, including power supplies, auxiliaries and filters may lay on the same printed circuit board.

8. The electronic system according to anyone of the preceding claim, wherein the chassis (10) might be attached, such as glued, bonded, connected or screwed on top of an external heat sink to provide an extension of the power dissipation capability of the said electronic system.

9. The electronic system according to anyone of the preceding claim, wherein the chassis (10) might be attached, such as glued, bonded, connected or screwed on top of an external chassis, such as motor chassis or UPS cabinets or solar converter chassis and to be used on outdoor.
